# EUROPEAN PATENT APPLICATION

(11) **EP 3 269 843 A1**
(43) Date of publication of application: **17.01.2018**
(21) Application number: 17180963.5
(22) Date of filing: 06.04.2007
(51) Int. Cl.: C23F 4/00, C23C 16/44, H01L 21/311, H01L 21/3213, B08B 7/00, H01J 37/32, C23C 14/56, H01L 21/3065

(54) **ETCHING PROCESS**

(30) Priority: 10.04.2006 EP 06007540; 21.04.2006 EP 06008238
(62) Divisional of application: 07727889.3
(71) Applicant: Solvay Fluor GmbH, 30173 Hannover (DE)
(72) Inventor: PISCHTIAK, Anja, 30451 Hannover (DE); SCHWARZE, Thomas, 31275 Ahlten (DE); PITTROFF, Michael, 30539 Hannover (DE)
(74) Representative: Mross, Stefan P.M.

(57) **Abstract**

Mixtures of fluorine and inert gases like nitrogen and/or argon can be used for etching of semiconductors, solar panels and flat panels (TFTs and LCDs), and for cleaning of semiconductor surfaces and plasma chambers. Preferably, fluorine is comprised in an amount of 15 to 25 vol.-% in binary mixtures. The gas mixtures can be used as substitute or drop-in for respective mixtures comprising NF₃ and permit a very flexible operation of plasma apparatus. For example, apparatus tuned for NF₃/Ar mixtures can be operated without further tuning using fluorine and argon, optionally together with nitrogen. The fluorine content is preferably in the range of 1 to 5 vol.-%, if ternary mixtures of fluorine, nitrogen and argon are used.

## Description

The present invention relates to a method for etching substrates using gases comprising F₂.

Chemical vapor deposition (CVD), physical vapor deposition (PVD) and atomic layer deposition (ALD) processes are widely used to produce semiconductors. By means of such processes, for example, SiOₓN_{y} (shortly referred to as SiON) layers can be prepared from the so-called TEOS/Ozone CVD process wherein tetraethoxysilane is treated in a plasma apparatus in the presence of ozone. SiO₂ can be deposited by thermal growth. Deposition of W, TiN and TaN are possible using PVD processes.

During operation of the respective apparatus, depositions not only occur on the substrates, but also on the inside walls of the reactor chamber. Regular removal of such deposits is desirable to obtain stable and repeatable deposition results with uniform surfaces at acceptable particle levels. The high requirements to sustain stable processes lead to frequent chamber cleaning. NF₃, which emerged as the main cleaning gas, is rather expensive.

US patent application 2003/0056388 discloses a cleaning gas for chamber cleaning which comprises SF₆ and F₂ and/or NF₃. US patent 5425842 discloses a process for chamber cleaning using F₂ or a fluorine compound and oxygen or an oxygen compound. With such gas mixtures, polymeric fluorocarbon contaminations can be removed. In a similar way, such contaminations on the surface of semiconductors can be removed. The contaminations are often formed when semiconductors are etched in a plasma chamber using fluorocarbons or hydrofluorocarbons as etching gas, such as CF₄, C₂F₆ and CHF₃, sometimes mixed with hydrogen.

NF₃ is often used as etching gas in the production of semiconductors. It can be used to etch inorganic coatings like SiON, amorphous Si, SiO₂, TiN, TaN or W (tungsten).

Problem of the present invention was to identify an etching gas composition which is effective as chamber cleaning gas and for other purposes in the field of semiconductor production with a significantly reduced environmentally destructive global warming emission. A special problem of the present invention is to identify an etching gas composition useful for etching inorganic materials, in the form of mixtures, which can be used especially for etching inorganic contaminations in the frame of chamber cleaning.

These and other objects of the present invention are achieved by the process according to the claims.

The process according to the present invention provides for the etching of semiconductor material (e.g. Reactive Ion Etching, in short: RIE), for surface cleaning and surface preparation of semiconductors, solar panels and flat panels (Thin Film Transistors, Liquid Crystal Displays, short: TFT/LCD application) and for cleaning of chambers for semiconductor production (TFT/LCD application) and is characterized by the application of a mixture of fluorine and one or more inert gases selected from the group consisting of nitrogen and the noble gases (He, Ar, Xe and Kr). In general, the fluorine content of the mixture is preferably between 1 and 35 vol.-% and more preferably between 15 and 25 vol.-%. In an especially preferred embodiment, the content of fluorine lies in the range of 18 to 22 vol.-%. The mixture can be formed in the reactor, or, which is preferred, a mixture of fluorine and the inert gas or gases is formed before introducing it into the reactor. If the gases are introduced in such a premixed form into the reactor, a homogenous mixture is provided throughout the reactor chamber. In cases where fluorine containing mixtures are used in a drop-in manner for NF₃, the fluorine content may be lower. This is explained below.

According to a preferred embodiment of the invention, the gas mixture consists of fluorine and the inert gas or inert gases, the fluorine being present within the range given above, and the inert gas or gases being balance to 100 vol.-%. Such gas mixtures can be advantageously be used for etching semiconductor material like SiON, amorphous Si, SiO₂, TiN, TaN or W, or for cleaning the surface of semiconductors or for cleaning chambers which are contaminated by inorganic materials like those mentioned above, or by organic material. Such organic material, as already was explained, may be formed when semiconductor material is etched using poly- or perfluorocarbon compounds. The treatment with the gas mixture can be performed in the presence of a plasma, or it can be performed plasma-free. In the latter case, the temperature expediently is 400°C or higher, preferably higher than 450°C, up to 650°C or even more. A range with good results is the range between 400 and 800°C, preferably 400 and 650°C, especially the range between 450 and 650°C.

Mixtures of fluorine with one inert gas, e.g. mixtures of fluorine and argon or mixtures of fluorine with nitrogen, have been found to be very efficient for the purposes mentioned above. They can be used in CVD, PVD or ALD processes performed in commercial apparatus. Some of these apparatus are tuned to operate with the gases currently often used for the treatments mentioned above. For example, such apparatus can be tuned to operate with a mixture of a certain inert gas and NF₃. If, instead, such an apparatus is operated with mixtures of fluorine and the respective inert gas the apparatus is tuned for, no problems should occur. Fluorine and the inert gases can be delivered as a mixture, or they can be delivered separately from each other. In the following, for this embodiment, the term "drop-in" will be applied. The term denotes that a process typically performed with NF₃/inert gas under substantially the same conditions, for example in view of the tuning of the apparatus, often also in view of the physical conditions of the gas in the reactor, for example the applied pressure and temperature in the reactor. In principle, a drop-in method includes the situation where an apparatus is operated alternating with NF₃/inert gas and F₂/inert gas. Preferably, the term "drop-in" denotes a situation where an apparatus which originally was tuned for and possibly operated with NF₃/inert gas mixtures, is permanently operated with F₂/inert gas mixtures.

This aspect of the invention will be further explained for a preferred embodiment which provides for the application of nitrogen, fluorine and argon in such a plasma apparatus.

The mixtures of fluorine and argon are for example excellent drop-in substitutes for mixtures comprising NF₃, especially for those comprising NF₃ and Ar. Analogously, mixtures of fluorine and nitrogen or fluorine and helium are excellent drop-in substitutes for apparatus operated with mixtures comprising said inert gases and NF₃. Usually, an apparatus tuned for NF₃ and a specific inert gas, e.g. argon, can be operated even with gas mixtures of fluorine and any other inert gas, if the specific inert gas, for which the apparatus is tuned for, is comprised in certain minimum amounts in the gas mixture of fluorine and the other kind of inert gas. For example, an apparatus tuned for mixtures of argon and NF₃, can be operated with mixtures of fluorine and nitrogen, provided that some argon is additionally introduced into the chamber. Often, a minimum amount of 50 vol.-% of argon is sufficient to keep the plasma operable without any tuning of the apparatus. This minimum amount is sometimes dependent from the specific apparatus, but can simply be found by checking the stability of the plasma. Of course, the additional inert gas needed in view of the tuning can be comprised in the mixture of fluorine and the other inert gas, or it can be supplied separately into the apparatus. Preferred noble gas is argon. From the foregoing, it is clear that in such preferred drop-in processes, F₂ gas is chosen instead of NF₃ as constituent of the gas mixtures further comprising inert gas.

It is preferred to apply fluorine, nitrogen and argon, whereby at least fluorine and nitrogen are supplied as a gas mixture. If fluorine and nitrogen are supplied as mixture separately from argon, the fluorine content in the nitrogen/fluorine mixture is preferably in the range of 15 to 25 vol.-%, as denoted above. If argon is supplied separately from the fluorine/nitrogen mixture, the volumes of the nitrogen/fluorine mixture and of argon are regulated in such a way that the content of argon in the sum of nitrogen/fluorine and argon is preferably at least 50 vol.-%. In principle, the content of fluorine in the sum of argon, nitrogen and fluorine gas forming a mixture in the reactor is flexible, it can be in the range of 1 to 25 vol.-%. The content of nitrogen in the sum of nitrogen, fluorine and argon gas in the reactor is also flexible; it can be in the range of 4 to 50 vol.-%. The argon preferably is the balance to 100 vol.-%. As mentioned above, fluorine and nitrogen are preferably supplied as mixture with a volume ratio of fluorine to nitrogen being preferably in the range of 15:85 to 25:75. Consequently, the contents of fluorine and nitrogen are in the lower range. It is especially preferred to deliver to the reactor chamber a nitrogen/fluorine mixture and argon whereby the sum of this gas supply consists of fluorine, nitrogen and argon wherein the content of fluorine is in the range of 1 to 5 vol.-%, the volume ratio of fluorine to nitrogen lies in the range of 15:85 to 25:75, and argon is the balance to 100 vol.-%. The most preferred range of fluorine is 1 to 4 vol.-%. Preferred volume ratio of fluorine to nitrogen is 18:82 to 22:78, and argon is the balance to 100 vol.-%.

Instead of being delivered separately by two different lines, the nitrogen/fluorine mixture and the argon can also be delivered in one line wherein they are premixed before entering the reactor chamber, or they can be provided premixed in the form of a ternary mixture. Such a ternary mixture can easily be prepared by condensing the desired amounts of fluorine, argon and nitrogen into a pressure bottle.

The use of mixtures of fluorine and an inert gas as drop-in for NF₃ and the inert gas in plasma-operated apparatus for treatment, for example, of semiconductors, solar panels, flat panels, in cleaning their surface and in chamber cleaning is another aspect of the present invention.

For most purposes, argon (Ar) is the preferred inert gas. For tungsten etch, N₂/F₂ is more efficient compared to Ar/F₂.

The process according to the present invention can be widely applied in the filed of semiconductor, solar panel and flat panel (TFT/LCD) manufacturing.

One aspect of the present invention concerns the etching of materials used in or being a result of semiconductor manufacturing. For example, the described mixture of fluorine and inert gas or inert gases can be used to etch inorganic materials, for example amorphous Si, and especially SiON, TaN, TiN, W and SiO₂. These materials are often produced via CVD, PVD or ALD processes during the production of semiconductors. The mixture can also be used to etch organic materials, such as photo resist. Here, advantageously the mixture is used together with oxygen.

In another aspect of the invention, the gas mixture outlined above is used for chamber cleaning or for cleaning the surface of semiconductor substrates, flat panels (TFT/LCD) and the like. As mentioned above, during CVD, PVD or ALD processes, inorganic or organic contamination may occur in the chambers used or even on the semiconductor material treated in the chambers.

For the etching of tungsten, the preferred mixture is composed of fluorine and nitrogen. For the etching of the other inorganic materials like SiON, TaN,

TiN, SiO₂ and amorphous Si, the preferred mixture is composed of fluorine and argon. Especially preferred are mixtures comprising 18 to 22 vol.-% of fluorine, the balance being nitrogen or argon, respectively, if binary mixtures are used. If ternary mixtures are used, which sometimes may be advantageous, the fluorine content once again is preferably in the range of 1 to 5 vol.-%.

Figure 1 shows the relative etch rate at 150°C, normalized in view of the fluorine content, for gas mixtures of fluorine with nitrogen or argon, applied to certain inorganic materials often used in semiconductor and flat panel manufacturing. A dotted line shows for comparison the etch rate of NF₃, set at 100 %. Figure 2 shows the results when etching is performed at 300°C.

Generally, the pressure during etching or chamber cleaning is lower than ambient pressure (1 bar), i.e. it is performed under vacuum. The etching is preferably performed at a pressure in the range of 100 to 2000 Pa. Very often, the pressure is preferably in the range of 100 to 1000 Pa, especially preferably at a pressure in the range of 200 to 800 Pa, and still more preferably in the range of 300 to 600 Pa. If desired, the etching can performed at lower or higher pressures than indicated, but with decreasing etch rate.

The temperature lies preferably in the range of ambient temperature (about 20°C) to 400°C, if the etching is performed in the presence of a plasma. Especially preferably, the temperature is in the range of 100°C to 400°C.

If the etching is performed plasma-free, preferred temperature ranges are given above.

According to another embodiment, the mixture of fluorine and inert gas is used for chamber cleaning. If the inside of the chamber is contaminated with W, a mixture of fluorine and nitrogen is very suitable. For other contaminants, mixtures of fluorine and argon are preferred. The preferred ranges of temperature and pressure correspond to those given above for etching.

Also in this embodiment, the mixtures can be used in a process performed plasma-free, or they can be used in a process supported by a plasma. If organic matter, like fluorinated polycarbon material, is to be removed, the addition of oxygen is advantageous.

The process according to the present invention can be performed in apparatus commonly used for preparing semiconductors, TFTs, LCDs, solar panels and flat panels. It can, for example, be used in CVD apparatus, PVD apparatus, or ALD apparatus working with or without plasma. The process is suitable for apparatus using a remote plasma, and for apparatus in which the plasma is produced directly in the chamber, be it induced by radio-frequency energy or by microwave energy.

In a preferred embodiment, fluorine and inert gas are introduced into the chamber not separately, but as a premixed homogenous mixture. Thereby it is guaranteed that a preset ratio of fluorine and inert gas is homogeneously provided throughout the reactor. If one uses ternary mixtures, they can be supplied in premixed form, or they can be supplied partially mixed into the reactor. A preferred embodiment provides for the supply of fluorine and argon or fluorine and nitrogen, which are already premixed, and, in the case of the latter, if desired an additional supply of argon which may be performed separately or even in the form of a ternary mixture with fluorine and nitrogen.

The advantage of the process according to the present invention is that NF₃ can be substituted by a gas mixture which is environmentally friendly in view of GWP and ozone; NF₃ has a very high GWP, while Ar, N₂, F₂ and their mixtures have zero GWP. It has been found that the gas mixtures according to the present invention are, for many applications, comparable and sometimes even better (e.g. when etching amorphous Si, SiON or SiO₂ at 150°C with F₂/Ar or F₂/N₂ or when etching TaN or SiON at 300°C using F₂/N₂, or when removing such contaminations in chamber cleaning) than the conventional etching or cleaning processes using NF₃, if one takes into account that NF₃ provides 3 F atoms, and F₂ only provides 2 F atoms. A further advantage of the process is that the mixtures of fluorine and an inert gas can be used as drop-in substitute for respective mixtures comprising fluorine instead of NF₃. If the apparatus is tuned for a mixture of NF₃ and a different inert gas (which means adjustment of the mass flow of the gas flow controllers and valves, heating of the samples plate, parameters like flow volume and flow speed, reactor temperature, homogeneity of the flow throughout the reactor, to achieve optimal etch gas effectiveness), additional supply of the inert gas for which the apparatus is tuned for provides for operable conditions. Thus, the apparatus can be operated in a most flexible way, without retuning it (which is very time-consuming and needs a lot of experimental work = design of experiment), and it is possible even to operate the apparatus at one time with NF₃ and at another time with fluorine without any undue delay.

Another aspect of the present invention concerns gas mixtures comprising or preferably consisting of fluorine and one or more inert gases selected from the group consisting of nitrogen and the noble gases. In a preferred embodiment, fluorine is comprised in binary mixtures in the range of 1 to 35 vol.-%. A content of fluorine in the range of 15 to 25 vol.-% in the binary mixtures is highly preferred, still more preferably a range of 18 to 22 vol.-%. Preferred noble gas is Ar. Especially preferred are mixtures consisting of 15 to 25 vol.-% fluorine and 75 to 85 vol.-% Ar, still more preferred are mixtures consisting of 18 to 22 vol.-% fluorine and 78 to 82 vol.-% Ar; most preferred are mixtures consisting of 20 vol.-% fluorine and 80 vol.-% Ar. Such binary mixtures can of course be used together with additionally supplied gases; e.g., binary mixtures comprising fluorine and nitrogen in the volume range given above can be used together with argon; consequently, the content of fluorine in the reactor chamber is reduced accordingly depending from the amount of argon supplied.

Another aspect of the invention relates to mixtures comprising or preferably consisting of fluorine, nitrogen and one or more of the noble gases. Ternary mixtures are preferred. The content of fluorine in such a ternary gas mixture is preferably in the range of 1 to 25 vol.-%, especially preferably in the range of 1 to 5 vol.-%. The content of nitrogen is preferably in the range of 4 to 50 vol.-%. The noble gas or noble gases preferably is or are the balance to 100 vol.-%. The volume ratio of fluorine to nitrogen lies especially preferably in the range of 15:85 to 25:75, still more preferably in the range of 18:82 to 22:78. Preferred noble gas is argon. Very preferred gas mixtures consist of fluorine, nitrogen and argon wherein the content of fluorine is in the range of 1 to 5 vol.-%, the volume ratio of fluorine to nitrogen lies in the range of 15:85 to 25:75, and argon is the balance to 100 vol.-%. In these mixtures, the preferred range of fluorine is 1 to 4 vol.-%. Preferred volume ratio of fluorine to nitrogen is 18:82 to 22:78, and argon is the balance to 100 vol.-%.

The advantage of these gas mixtures is that they are very suitable for application in the semiconductor industry such as reactive ion etching, chamber cleaning or for cleaning the surface of semiconductor substrates, solar panels flat panels (TFT/LCD) and the like.

Another aspect of the present invention is an apparatus suitable for treating, especially for etching or surface-cleaning of semiconductors, solar panels or flat panels (TFT and LCDs), which is tuned for NF₃ comprising gases, but which comprises a gas mixture which comprises fluorine and one or more inert gases selected from nitrogen and the noble gases. The meaning of tuning has been described above : adjustment of the mass flow of the gas flow controllers and valves etc so that the apparatus is suited for the use of the NF₃ containing gas. In a preferred embodiment, the apparatus is connected, e.g. via a line, with one or more containers such as pressure bottles comprising the fluorine containing gas mixtures mentioned above.

Still another aspect of the present invention is the use of fluorine as a drop-in substitute for NF₃ as a component of gas mixtures applied in plasma-supported treatment apparatus, such as those for chamber cleaning, surface treatment or etching of semiconductors, solar panels and flat panels (TFTs and LCDs). The preferred use is in plasma apparatus which are tuned for NF₃ containing gases, but which are operated with fluorine containing gases as a substitute. The fluorine containing gases can of course substitute gas mixtures of NF₃ with e.g. argon, which are supplied separately into the reactor, and only form a mixture in the apparatus, but they can also substitute such NF₃ containing mixtures which are supplied into the reactor in premixed form.

The advantage of this use is that no tuning to the different gas mixture has to be performed, so time and money can be saved by the drop-in type of use.

The following examples shall explain the invention in further detail, but they are not intended to limit the scope of the invention.

### Examples :

### Used apparatus :

Experiments were performed in a custom-made stainless steel vacuum chamber (26 liters volume) with an attached remote Astron Astex plasma source, made by MKS Astron, operated at 13.56 MHz, located 32 cm above the sample. The chamber was evacuated with a turbo molecular pimp and a BOC Edwards dry pump. The exhaust gases were analyzed by mass spectroscopy; a differentially pumped Leybold-Inficon Transpector 200 amu unit was used. Samples were placed on a chuck in the center of the reactor chamber. The temperature in the chamber was controlled and could be varied between room temperature (around 20°C) and 300°C.

Before the experiments were performed, the vacuum system was passivated by first flushing it with low flow of F₂/N₂, then for several hours at high F₂/N₂ pressure without any flow. This was repeated twice.

The F₂/Ar and F₂/N₂ mixtures were used in a volume ratio of 20:80, stored in 2-liter pressure bottles filled up to 10 and 38 bar, respectively.

The remote plasma source was usually ignited in the presence of pure argon. Directly after the plasma was in a stable condition, the gas mixture comprising fluorine was introduced. Mixtures of fluorine and argon could be supplied in drop-in manner without any problem. Since the apparatus used was tuned for Ar/NF₃ mixtures, to obtain a stable plasma, argon was continually supplied additionally to the apparatus when a mixture of fluorine and nitrogen as inert gas was used. In this manner, the fluorine/nitrogen mixtures could be used in a drop-in manner. Delivery of fluorine/ nitrogen and argon separately allows fine tuning of the argon content. Using ternary mixtures of fluorine, nitrogen and argon has the advantage that the mixtures are already homogenous when delivered to the reactor.

### Determination of etch rates :

The etch rates were determined in situ by reflectrometry using a 645 nm laser directed to the sample. The etch rate was calculated by dividing the thickness of the film by the time when the removal endpoint was detected.

### Preparation of the mixtures of argon and fluorine and nitrogen and fluorine :

Argon and fluorine were condensed in a volume ratio of 20:80 into a 2-liter pressure bottle filled up to a pressure of 10 Bar, thereby forming a homogeneous mixture of both compounds.

Nitrogen and fluorine were condensed in a volume ratio of 20:80 into a 2-liter pressure bottle filled up to 38 Bar, thereby forming a homogenous mixture of both compounds.

### Samples :

The size of the samples was 20×20 mm². The investigated material was deposited on a 150 nm thermal SiO₂ layer to allow interferometric measurement. The SiON and SiO₂ samples were deposited on bulk silicon since their optical properties allow interferometric measurements.

The following samples were used :
a) 1000 nm SiOₓN_{y} (referred to as SiON) on bulk silicon, deposited by a conventional TEOS/ozone CVD process
b) 1000 nm SiO₂, thermally grown on bulk silicon
c) 300 nm tungsten, deposited by a conventional PVD process
d) 300 nm TiN, deposited by a conventional PVD process
e) 200 nm TaN, deposited by a conventional PVD process

Up to 300°C, no etching was observed under plasma-free conditions. This was verified by the lacking of a peak for SiF₄ in a QMS (quadrupol mass spectrometer) measurement.

### Example 1 : Etching of SiON using a mixture of fluorine and nitrogen with volume ratio of 20:80

a) The temperature in the reactor was set to 150°C, the plasma was ignited with argon, and immediately after plasma ignition, the F₂/N₂ mixture was introduced into the reactor with a flow rate of 100 sccm. Argon was additionally introduced in a flow rate of 640 sccm. The relative etch rate was determined for pressures of 100 Pa, 200 Pa, 400 Pa and 800 Pa. It was found that the etch rate was at an optimum at 400 Pa.
b) The example was repeated with an argon gas flow of 900 sccm and an F₂/N₂ gas flow of 100 sccm. Again, the optimum was found for 400 Pa, but the relative etch rate was lower due to the lower concentration of fluorine.

### Comparison example 1 : Etching of SiON using a mixture of argon and NF₃

Example 1 was repeated introducing argon and NF₃ in flows of 350 sccm and 20 sccm, respectively. Also here, the optimal etch rate was observed at 400 Pa.

Result: After normalizing the fluorine content (because NF₃ delivers 3 F atoms while F₂ delivers only 2), the relative etch rate of example 1a) was slighter higher than that of the comparison example 1, while the etch rate of example 1b) was slightly lower.

### Example 2 : Etching SiON with an argon/fluorine mixture

A mixture of argon and fluorine (volume ratio 80:20) was introduced into the reactor in a flow of 100 sccm at various pressures and temperatures. It was found that, independently of the temperature, the optimal relate etch rate was achieved at a pressure of 400 Pa. The highest etch rate was observed at 300°C.

Result: At 300°C, the etch rates of 100 sccm Ar/fluorine match those of 20 sccm NF3 by 50 to 60%. The mass equivalent of 10.7 sccm of NF₃ to 20 sccm F₂ (comprised in the Ar/fluorine mixture) achieves slightly less etching rates; therefore, etch rates per mass unit of Ar/F₂ are slightly better.

### Example 3 : Etching of SiO₂, TiN, TaN and W

In analogy to examples 1 and 2 and comparison example 1, SiO₂, TiN, TaN and W were etched with mixtures of argon/fluorine, nitrogen/fluorine (with additional argon supply for plasma stabilization) and, for comparison, with NF₃.

### a) Etching performed at 150°C :

The relative etch rates, normalized for the fluorine content, are compiled in figure 1/2. It can be seen that the mixture of fluorine and nitrogen is comparable or even clearly higher for W and SiON, when compared to NF₃ (set as 100 %, indicated by the dotted line). The mixture of fluorine and argon is comparable or even clearly higher for SiON, TiN and SiO₂, when compared to NF₃. TaN can be etched by fluorine and argon in a competitive range compared to NF₃; tungsten etching with a mixture of fluorine and argon is possible, but the etch rate is comparatively low.

### b) Etching performed at 300°C :

Results are compiled in figure 2/2. With the argon/fluorine mixture, a very high etch rate is achieved for TaN, with the nitrogen/fluorine mixture, SiON etching is very effective. For etching of TiN and SiON, argon/fluorine is competitive to NF₃, as is the etching of W and SiON with the mixture of nitrogen and fluorine (with additional supply of argon, as described, for plasma stabilization). Etching of W using argon/fluorine is possible, but with a comparatively low etch rate.

### Example 4 : Plasma-supported chamber cleaning

a) Plasma chambers contaminated by inorganic materials like SiO₂, SiON, TiN, TaN and W can be cleaned using mixtures of argon and fluorine or nitrogen and fluorine (advantageously again with additional argon supply, if the reactor is tuned for NF₃/Ar). The plasma is started with argon, and then the etching gas mixture (which here is a cleaning gas mixture) is introduced into the reactor. The pressure lies preferably in the range of 100 to 800 Pa, with an optimum at 400 Pa. The temperature is preferably in the range of 150 to 300°C. Treatment is performed until the desired degree of cleaning is achieved. Gaseous reaction products (like SiF₄) formed from the contaminants can be removed by applying a vacuum to the cleaned reactor chamber.
   Such a cleaning step can be performed in regular intervals, whenever such cleaning is desirable.
b) Plasma chambers may be contaminated by organic material, e.g. polymeric carbon material which may be partially or completely fluorinated. This contamination can occur if semiconductors or flat panels are etched under plasma conditions using fluorocarbons or hydrofluorocarbons, e.g. CF4₄, C₂F₆ or CHF₃, as etching gas. Chambers contaminated by such organic material are cleaned at a temperature of 250°C using mixtures of argon and fluorine or nitrogen and fluorine, respectively as described in example 4a). Again, the plasma is started using argon, and then the cleaning gas is introduced into the chamber. It is highly preferable also to introduce oxygen into the chamber to be cleaned. The reaction products formed from the organic contaminants like CO₂, (hydro)fluorocarbon products or carbonyl fluoride, can be removed from the cleaned chamber by applying a vacuum. This chamber cleaning can be performed regularly, whenever such a cleaning operation is desirable.

### Example 5 : Surface cleaning of semiconductors, flat panels and the like

Semiconductors, flat panels and the like often are etched using fluorocarbon or hydrofluorocarbon etching gases, such as CF₄, C₂F₆ or CHF₃. Under plasma conditions, organic material may not only form in the inside of the reactor chamber, but also on the surface of the etched semiconductor or flat panel. Such surface contaminations can be removed using mixtures of argon and fluorine or nitrogen and fluorine, respectively. As to pressure and temperature, preferred ranges are given in example 4a. As in example 4b, the reaction products can be removed from the chamber wherein the semiconductor or flat panel is located by applying a vacuum.

### Example 6 : Plasma-free operations

Etching, chamber cleaning and surface cleaning of semiconductors, flat panels and the like can be performed under plasma-free conditions. Here, the temperature is preferably set to at least 400°C, but can be considerably higher, up to 650°C , up to 800°C or even more. If desired, the etching or cleaning operation can be supported by UV light.

### Example 7 : Chamber cleaning using a ternary mixture consisting of nitrogen, fluorine and argon

### A) Preparation of the gas mixture : fluorine, nitrogen and argon are condensed into a pressure bottle in volume ratios given in the following table (data given in vol.-%) :

| Example | Fluorine | Nitrogen | Argon |
|---|---|---|---|
| 7.1 | 1.8 | 7.2 | 91 |
| 7.2 | 2.25 | 9 | 88.75 |
| 7.3 | 2.6 | 10.4 | 87 |

It has to be noted that the gas mixtures of examples 7.1 to 7.3 can also be prepared by pressing a gas mixture of fluorine and nitrogen (volume ratio 20:80) into the pressure bottle and, prior or afterwards, adding argon.

### B) Application of the ternary mixtures for etching :

The mixtures of the examples 7.1 to 7.3, which are perfectly homogenous, can be used for etching of semiconductors or for chamber cleaning in analogy to examples 1 to 6. Advantage is that the ternary mixtures are already in a homogenous form before they are introduced into the reactor chamber.

### Example 8 : Treatment of amorphous Si

Amorphous Si can be produced in the frame of semiconductor, solar or flat panel production in plasma-free or plasma-supported CVD apparatus. An undesired deposit occurs in the chamber, often close to the source of the silicium precursor.

### 8.1 Plasma-supported chamber cleaning

A plasma chamber with undesired deposits of amorphous Si is treated with fluorine/argon, fluorine/nitrogen mixtures (volume ratio 20:80) or with ternary mixtures comprising 90 vol.-% Ar, the balance to 100 vol.-% being a mixture of fluorine and nitrogen (volume ratio 20:80) at a pressure of 400 Pa and a temperature of 250°C.

### 8.2. Plasma-free chamber cleaning

A reactor chamber with undesired deposits of amorphous Si is treated with a mixture of fluorine and nitrogen (volume ratio 20:80) at a temperature of 700°C to remove the Si deposits.

## Claims

1. Process for etching or cleaning the surface of semiconductor material, solar panels or flat panels (TFTs and LCDs), or cleaning chambers of apparatus used for semiconductor manufacturing, **characterized in that** a mixture is applied comprising fluorine, nitrogen and one or more of the noble gases.

2. Process according to claim 1, **characterized in that** a ternary mixture is used comprising fluorine, nitrogen and argon.

3. Process according to claim 1 or 2, **characterized in that** the pressure is in the range between 100 and 2000 Pa, preferably 100 and 800 Pa, especially preferably 200 and 600 Pa.

4. Process according to one of the preceding claims, **characterized in that** the process is plasma-supported and the temperature lies in the range between 100 and 350°C, preferably between 150 and 300°C.

5. Process according to one of the preceding claims, **characterized in that** inorganic material is etched, or that chambers are cleaned which are contaminated by inorganic material wherein the inorganic material is amorphous Si, SiOₓN_{y}, SiO₂, TaN, TiN or W.

6. Process according to one of the preceding claims, **characterized in that** organic material is removed from the surface of semiconductors, solar panels or flat panels (TFTs and LCDs), or that chambers contaminated with organic material are cleaned.

7. Process according to claim 6, **characterized in that** the organic material is a fluorinated polymer originating from etching semiconductors, solar panels or flat panels (TFTs and LCDs) with fluorinated carbon compounds, optionally in the presence of hydrogen, as etching gas.

8. Gas mixture comprising fluorine, nitrogen and one or more of the noble gases.

9. The gas mixture according to claim 8, comprising fluorine, nitrogen and argon.

10. The gas mixture according to claim 8 or 9, wherein the fluorine content is in the range of 1 to 25 vol.- % and the volume ratio of fluorine to nitrogen is in the range of 15:85 to 25:75.
